# FASCICULE DE BREVET EUROPEEN

(11) **EP 2 612 244 B1**
(45) Date de publication et mention de la délivrance du brevet: **04.06.2014**
(21) Numéro de dépôt: 11746255.6
(22) Date de dépôt: 23.08.2011
(51) Int. Cl.: G01R 31/28, G01R 31/26, G06F 11/22, G01R 31/3185, G06F 11/267

(54) **PROCEDE DE TEST EN LIGNE DES ETAGES DE PIPELINE TEMPORAIREMENT NON UTILISES ET SON DISPOSITIF ASSOCIE**
VERFAHREN ZUM ONLINE-TESTEN VON VORÜBERGEHEND UNBENUTZTEN PIPELINE-STUFEN UND ZUGEHÖRIGE VORRICHTUNG
METHOD FOR THE ON-LINE TESTING OF PIPELINE STAGES TEMPORARILY NOT IN USE, AND ASSOCIATED DEVICE

(30) Priorité: 02.09.2010 FR 1056965
(43) Date de publication de la demande: 10.07.2013
(73) Titulaire: Commissariat à l'Énergie Atomique et aux Énergies Alternatives, 75015 Paris (FR)
(72) Inventeur: GHERMAN, Valentin, F-91300 Massy Palaiseau (FR); BONHOMME, Yannick, 91650 Breuillet (FR)
(74) Mandataire: Dudouit, Isabelle
(86) Numéro de dépôt international: PCT/EP2011/064428
(87) Numéro de publication internationale: WO 2012/028490

(56) Documents cités:
- US-A1- 2005 172 172
- US-A1- 2008 141 088
- US-A1- 2009 138 772

## Description

L'invention concerne un procédé de test des étages temporairement non-utilisés dans un pipeline et des dispositifs apparentés. L'invention s'applique notamment aux domaines des micro-technologies et des nanotechnologies.

L'invention peut être utilisée, par exemple, pour la détection des fautes de délai apparues lors de la phase de production ou dues au vieillissement des circuits numériques pipelinés, ou encore des fautes transitoires produites par des interférences avec l'environnement ou par la radioactivité de certaines impuretés dans les matériaux composant lesdits circuits.

Le terme pipeline désigne un circuit numérique partitionné en plusieurs étages séparés par des buffers, chaque étage pouvant exécuter dans chaque cycle d'horloge une opération. Les pipelines peuvent être rencontrés dans les coeurs des processeurs ou les systèmes d'interconnexions par exemple.

Dans les pipelines où les opérations sont exécutées en ordre, c'est-à-dire dans le même ordre que celui dans lequel elles sont entrées, des cycles non-utilisés traversent tous les étages du pipeline situés entre l'étage où ils sont apparus et la ou les sorties du pipeline, exactement comme les bulles de gaz se propagent dans une bouteille d'eau minérale. Dans la suite, de tels cycles non-utilisés dans le pipeline seront appelés tout simplement "bulles". Par exemple, dans le cas d'un coeur de processeur, ces bulles peuvent apparaître à cause des défauts de lecture d'instructions (le terme anglo-saxon est "fetch-miss"), des instructions nop (terme qui vient de l'anglais "no operation"), ou des instructions de branchement comme par exemple les sauts d'adresse.

Une opération est dite « valide » si le résultat de son exécution peut avoir un effet sur le résultat d'une tache ou d'un programme qui doit être exécuté par un dispositif de type pipeline.

Le terme vecteur de test est utilisé pour indiquer l'état d'un buffer à l'entrée d'un étage de pipeline pendant la phase de test.

Dans les circuits réalisés à base de micro-technologies et nanotechnologies, les fautes résultant de défauts physiques dus au vieillissement peuvent engendrer des erreurs de fonctionnement et finalement la défaillance du système. De plus, la très forte miniaturisation de ces circuits diminue la quantité de charge électrique nécessaire pour changer le niveau logique d'un signal, ce qui favorise implicitement l'apparition des fautes transitoires.

Dans les systèmes numériques réalisés à base de technologies nanométriques, les approches actuelles qui permettent le monitoring du vieillissement sont trop onéreuses en termes de surface et de puissance ou bien ils ont un taux de couverture limité concernant les fautes liées au vieillissement.

En général, la majorité des défauts liés au vieillissement ont la propriété de se manifester par une augmentation progressive de la latence du circuit. Par conséquent, ces défauts vont induire des fautes de délai dont l'amplitude augmente progressivement dans le temps. C'est cette propriété qui va être utilisée pour diminuer massivement la latence de détection et même passer de la détection des fautes liées au vieillissement à leur prédiction.

La demande de brevet US 2005/172172 décrit un procédé et un dispositif de test de dispositifs de type pipeline dans un microprocesseur, pendant les cycles non utilisés. Le procédé utilise une valeur connue pré-stockée pour réaliser la comparaison avec la sortie du pipeline sous test afin de déterminer la présence d'erreurs.

La demande de brevet US 2009/138772 décrit un procédé et un dispositif de test de microprocesseurs qui utilise aussi les cycles non utilisés pendant l'opération des microprocesseurs. Le procédé utilise une valeur de logique prédéterminée.

L'invention a notamment pour objet un procédé de test de « bon fonctionnement » d'un dispositif pipeline, permettant la détection de fautes de délai et/ou la détection de fautes transitoires, le procédé utilisant notamment la génération et la gestion de vecteurs de test dans les étages du pipeline et mettant à profit des cycles d'horloge pendant lesquels les étages du pipeline ne sont pas utilisés.

L'invention concerne un procédé de test en ligne de dispositifs de type pipeline, ledit dispositif de type pipeline comportant une succession d'étages séparés par des buffers, chaque buffer étant en liaison avec un signal idle, ou valide = not idle, et/ou au moins un bit de statut caractérisé en ce qu'il comporte en combinaison au moins les étapes suivantes :
a) détecter les valeurs du signal idle et/ou des bits de statut correspondants traduisant la non utilisation d'un cycle ou l'interruption brusque du flot d'opérations dans un pipeline et indiquant qu'une opération (O₃) exécutée par un étage du pipeline dite opération valide est suivie par un cycle non utilisé,
b) maintenir l'état du buffer afin de permettre la réexécution de ladite opération valide (O₃) pendant le cycle non utilisé indiqué par ledit signal idle,
c) réexécuter pendant le cycle non utilisé l'opération valide (O₃) afin d'obtenir au moins une première version (O'₃) et une deuxième version (O"₃) de ladite opération valide (O₃),
d) mémoriser en sortie du pipeline les résultats qui correspondent à la première version (O'₃) de ladite opération (O₃) répliquée ou réexécutée afin de les comparer aux résultats correspondant à ladite deuxième version (O"₃) de la même opération (O₃) répliquée ou réexécutée,
e) comparer les résultats obtenus en sortie du pipeline qui correspondent à la première version (O'₃) et à la deuxième version (O"₃) et s'il existe une différence indiquer la présence d'une erreur.

Le signal idle peut être observé à l'entrée du pipeline, ou à n'importe quel étage du pipeline.

Au niveau de l'étape b) la dernière opération valide avant un cycle non-utilisé est, par exemple, ré-exécutée sur plusieurs cycles successifs.

L'exécution de la première instanciation d'une opération répliquée peut être effectuée en mode dégradé.

L'opération de mémorisation d) des valeurs obtenues par les différentes instanciations d'une opération répliquée est exécutée en utilisant un buffer dupliqué en sortie du pipeline.

L'opération de comparaison est, par exemple, exécutée à la sortie de chacun des étages constituant le pipeline.

Selon une variante de mise en oeuvre, on introduit un cycle non utilisé ou bulle à l'entrée du pipeline après chaque opération qui n'est pas naturellement suivie par un cycle non utilisé et on vérifie les résultats de chaque opération en sortie du pipeline ou au niveau de chacun des étages du pipeline.

On peut utiliser un encodage naïf de l'information qui décrit le type d'opération exécutée par chaque étage dans le pipeline défini de la manière suivante : on associe un bit de statut à chaque buffer, sauf le premier buffer dans le pipeline, de telle façon que le bit de statut d'un buffer à l'entrée d'un étage exécutant une opération qui correspond à une réexécution de l'opération dans l'étage précédente prend la valeur s'∈ {0, 1} et s=not(s') dans les autres cas.

Dans le cas où l'étape de comparaison e) est effectuée en sortie du pipeline, le procédé utilise une bascule supplémentaire associée au buffer de sortie, ladite bascule supplémentaire stockant le bit de statut de ce buffer pendant le cycle précédent.

Selon une variante de réalisation, il est possible d'utiliser deux bits de statut dans le cas où les opérations ont plus que deux répliques afin de distinguer entre les opérations non-répliquées et la première version, les versions suivantes et la dernière version d'une opération répliquée, chacun des bits de statut pouvant être encodé séparément.

Le procédé peut être utilisé pour des pipelines dans les coeurs des processeurs où des cycles temporairement non utilisés sont obtenus en insérant des opérations de type « no opération », ou pour des pipelines dans les systèmes d'interconnections où les bits de statut sont décalées d'un étage de pipeline en avant, ou encore pour des pipelines dans les systèmes d'interconnections où des cycles temporairement non utilisés sont inclus dans les tables de gestion ou sont générés par un arbitre central.

L'invention concerne aussi un dispositif de test en ligne pour des dispositifs de type pipeline composés d'une succession d'étages séparés par des buffers, caractérisé en ce qu'il comporte au moins les éléments suivants : un moyen d'encodage naïf des types d'opération existantes dans les étages dudit pipeline, indiquant les opérations dupliquées et leurs versions, constitué d'un bit de statut associé à chaque buffer à la fin d'un étage de pipeline de telle façon que le bit de statut d'un buffer à l'entrée d'un étage exécutant une opération qui correspond à une réexécution dans l'étage précédente prend la valeur s'∈ {0, 1} et s=not(s') dans les autres cas afin de sélectionner le mode dégradé pour les buffers à la fin de chaque étage de pipeline qui exécute la première version d'une opération dupliquée, de comparer les résultats et de choisir entre les résultats produits par les deux versions d'une opération dupliquée.

Le dispositif peut comporter une bascule pour stocker chaque bit de statut.

Selon un mode de réalisation du dispositif le bit de statut s' prend la valeur {s, s'}, le bit de statut s=not(s') prend la valeur {s', s}, chaque paire de bits de statut étant obtenus à partir d'un signal indiquant l'absence d'une opération valide à l'entrée du pipeline et à partir de ce même signal inversé par un inverseur, et comporte des moyens permettant d'identifier l'apparition de la combinaison (s, s') afin de sélectionner le mode dégradé pour les buffers à la fin de chaque étage de pipeline qui exécute la première version d'une opération dupliquée, de comparer les résultats et de choisir entre les résultats produits par les deux versions d'une opération dupliquée.

Les moyens d'identification de l'apparition de la combinaison (s, s') sont, par exemple, choisis parmi la liste des moyens suivants : les portes ET logique si le paramètre s est égal à 0, des portes OU logique inversé lorsque s=1.

L'information transportée par le bit de statut associé à un buffer peut être donnée par la comparaison avec le bit du statut du buffer suivant, la valeur du premier bit de statut dans le pipeline pendant un cycle d'horloge étant obtenu à partir de sa valeur pendant le cycle d'horloge précédant comparée avec le signal d'entrée indiquant l'absence d'une opération valide à l'entrée du pipeline, et en ce qu'il comporte des portes OU exclusif logique (XOR), et des inverseurs logiques permettant d'identifier les opérations dupliquées et leur versions afin de sélectionner le mode dégradé pour les buffers à la fin de chaque étage de pipeline qui exécute la première version d'une opération dupliquée, de comparer les résultats et de choisir entre les résultats produits par les deux versions d'une opération dupliquée.

Selon un mode de réalisation, un buffer comporte un nombre double de bits de statut dans le cas où les opérations ont plus que deux répliques afin de distinguer entre les opérations non-répliquées et la première version, les versions suivantes et la dernière version d'une opération répliquée, chacun des bits de statut pouvant être encodé séparément.

D'autres caractéristiques et avantages de l'invention apparaîtront mieux à l'aide de la description qui suit, donnée à titre illustratif et non limitatif, faite en regard des dessins annexés parmi lesquels:
- la figure 1, présente un exemple de mise en oeuvre du procédé de test selon l'invention des étages temporairement non-utilisés dans un pipeline,
- la figure 2, présente un dispositif avec un encodage naïf de l'information qui permet la distinction entre deux types d'opération dans les étages d'un pipeline,
- la figure 3, présente un dispositif avec un encodage de l'information qui permet la distinction entre deux types d'opération dans les étages d'un pipeline, qui est robuste contre les fautes de délai et les fautes transitoires mais qui nécessite un double coût par rapport au dispositif de la figure 2, et
- la figure 4, présente un dispositif avec un encodage de l'information qui permet la distinction entre deux types d'opération dans les étages d'un pipeline, qui est robuste contre les fautes de délai et les fautes transitoires et qui nécessite le même coût que le dispositif en figure 2.

### Principe de base

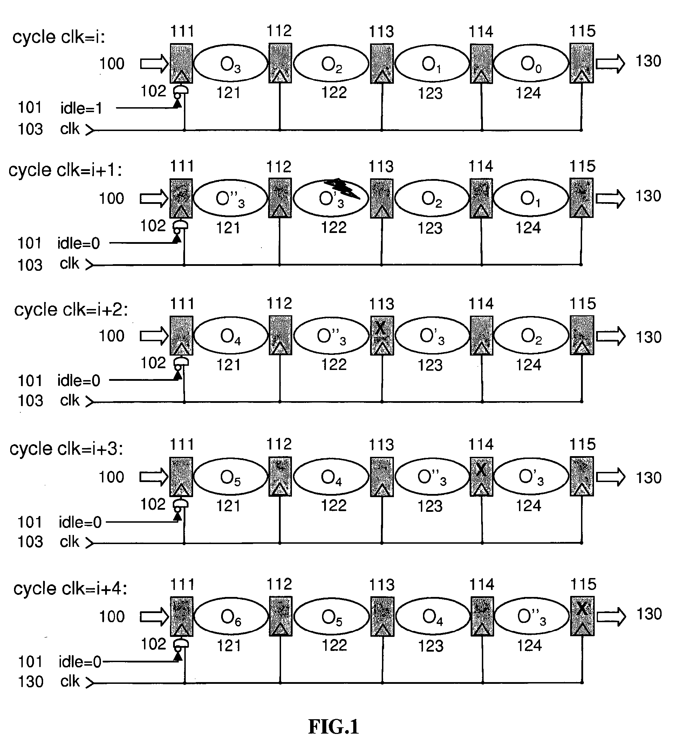

L'exemple donné à la figure 1 présente un exemple de procédé de test de bon fonctionnement, selon l'invention, des étages d'un pipeline. Sur cette figure 1, l'état du pipeline a été représenté pour 5 cycles d'horloge schématisés par cycle ou clk référencés en commençant par i, i+1,.. i+4.

La figure 1 présente le procédé de test des étages non-utilisés dans un pipeline composé de quatre étages combinatoires 121, 122, 123, et 124, chacun des étages étant séparé par un buffer respectivement 112, 113 et 114. Deux buffers supplémentaires 111 et 115 sont placés à l'entrée et, respectivement, à la sortie du pipeline.

Le signal « idle » correspond à un mécanisme connu de l'art antérieur, mécanisme à l'entrée d'un pipeline ou au niveau d'autres étages du pipeline qui indique si une nouvelle opération est disponible ou non. Ainsi, l'absence d'une nouvelle opération valide est indiquée, par exemple, par le signal 101 (idle). Le signal 101 est utilisé pour bloquer le premier buffer 111, par exemple, du pipeline afin de pouvoir démarrer la réexécution d'une opération selon les étapes caractéristiques du procédé de test selon l'invention. Le blocage du premier buffer du pipeline est symbolisé dans cet exemple de mise en oeuvre par la porte 102 qui implémente l'operateur ET logique (AND) et qui reçoit comme entrées le signal 101 (idle) inversé et un signal d'horloge 103.

Ce mécanisme peut aussi être utilisé dans tous les étages du pipeline afin de pouvoir spéculer à tout moment l'apparition d'une opération invalide.

Sans sortir du cadre de l'invention, d'autres types de signaux qui indiquent l'interruption brusque du flot d'opérations dans un pipeline peuvent être utilisés afin d'indiquer l'apparition d'une bulle à l'intérieur du pipeline. Ces signaux peuvent bloquer tous les buffers 111, 112, 113 et 114.

Le procédé de test proposé selon l'invention est basé sur la réexécution de la dernière opération exécutée avant un cycle non-utilisé dans un ou plusieurs étages du pipeline. Une telle situation est illustrée en figure 1, où pendant le cycle clk=i le signal idle=1 indique que l'opération O₃ exécutée par le premier étage du pipeline sera suivi par un cycle non-utilisé ou autrement dit par une instruction non-valide. A la place de détecter les valeurs du signal idle, il est possible de détecter les bits de statut correspondants indiquant qu'une opération O₃ exécutée par un étage du pipeline dite opération valide est suivie par un cycle non utilisé.

La réexécution d'une opération pendant un cycle non utilisé, l'opération O₃ dans cet exemple, par le même matériel à des cycles successifs i+1, i+2, i+3, ...permet notamment la détection des fautes de délai et implicitement la détection d'une grande majorité des défauts dus au vieillissement du circuit ou dispositif apparentés à un pipeline.

Dans cet exemple, les opérations O₂ et O₃ offrent une paire de vecteurs pour le test des fautes de délai dans les étages traversés. L'opération O₂ assure l'initialisation des fautes de délai (vecteur d'initialisation), tandis que l'opération O₃ offre un vecteur d'activation au cours du cycle suivant. La vérification de la réponse de chaque étage du pipeline à cette paire de vecteurs de test est facilitée par la réexécution de l'opération O₃. O₃ est répliquée ou réexécutée (du fait de sa réexécution au cours du cycle non-utilisé) et devient une première version O'₃, 122, et une deuxième version O"₃, 121, de ladite opération valide O₃. En relâchant le maintien du buffer au cycle d'horloge clk=i+1 et aux cycles qui suivent, les opérations O₄, O₅, O₆ apparaissent ensuite. En sortie du pipeline, les résultats de la première version O'₃ seront mémorisés afin d'être comparés avec les résultats de la deuxième version O"₃.

Si une erreur apparaît pendant l'exécution d'une des instanciations d'une opération répliquée ou réexécutée, elle sera propagée jusqu'à la sortie du pipeline si elle n'est pas logiquement masquée.

Par exemple, la figure 1 montre une erreur qui apparaît dans le deuxième étage 122 (symbolisé par un éclair E dans la partie combinatoire puis par une croix dans la partie buffer 113 au cycle clk =i+2) et qui arrive à la sortie du pipeline 115 après trois cycles supplémentaires clk =i+2, clk=i+3, clk =i+4 (non représenté sur la figure).

Afin de permettre la comparaison des résultats produits par les différentes instanciations d'une opération répliquée, comme O₃, une manière de procéder est de dupliquer le buffer de sortie 115. Cette duplication permet de stocker le résultat ROi₁ₑᵣ de la première exécution d'une opération répliquée et de le comparer avec le résultat ROi_{2nd} de l'autre réplique.

Cette solution permet de réduire le coût de l'implémentation mais peut aussi diminuer la couverture de fautes de délai à cause du masquage logique qui peut empêcher la propagation des effets d'une faute d'un étage à l'autre. Ce masquage logique est faible dans le pipeline d'un système d'interconnexion, mais il peut devenir important dans le pipeline d'un coeur de processeur.

### Variante avec comparaison à la sortie de chaque étage

Afin de maximiser le taux de couverture, la comparaison des résultats des différentes versions d'une opération répliquée peut être faite à la sortie de chaque étage. Cette vérification nécessite, dans cet exemple, une porte logique de type XOR pour comparer la sortie et l'entrée de chaque bascule dans les buffers à la sortie de chaque étage. Dans ce dernier cas, la duplication du dernier buffer 115 dans le pipeline n'est plus nécessaire.

### Variante avec mise en oeuvre du mode dégradé

Selon un mode de mise en oeuvre permettant la prédiction des erreurs dues aux fautes de délai, l'exécution de la première instanciation de l'opération O₃ est réalisée en mode dégradé, c'est à dire dans un mode dans lequel les étages du pipeline qui exécutent cette opération ont moins de marge temporelle pour tolérer l'arrivée tardive des signaux à leurs sorties. Cette dégradation augmente la probabilité qu'une faute de délai induite par un défaut de vieillissement affecte d'abord les opérations répliquées. Le mode dégradé ne fait pas l'objet de ce brevet. Un exemple de mode dégradé est explicité dans une demande de brevet du Demandeur déposée le même jour que la présente demande de brevet ou encore dans la publication de S.Shyam et al intitulée « Ultra low-cost defect protection for microprocessor pipelines », publiée dans le journal « Architectural Support for Programming Languages and Operating Systems », pp.73-82, 2006.

### Protection contre les fautes transitoires

Afin d'assurer la protection contre les fautes transitoires qui sont intrinsèquement imprédictibles, une variante de mise en oeuvre du procédé selon l'invention va protéger chaque opération.

Pour obtenir ce résultat, des bulles vont être insérées à l'entrée du pipeline après chaque opération qui n'est pas naturellement suivie par une bulle. Ceci permet la réexécution systématique des opérations tout au long de leur parcours dans le pipeline. Comme la vérification de chaque opération peut être faite le plus tard à la sortie du pipeline, la latence de détection est quasi-inexistante et l'utilisation du mode dégradé n'est plus impérative. Il devient ainsi possible de vérifier systématiquement les résultats de chaque opération et d'arriver à une latence de détection quasi-inexistante pour les fautes transitoires et pour les fautes de délai.

### Augmenter le taux de couverture pendant l'exécution des programmes de test

La réplication et la vérification systématiques des instructions peuvent être aussi utilisées pendant l'exécution de programmes de test des processeurs afin d'augmenter l'observabilité des fautes et implicitement leurs taux de couverture. Dans ce cas aussi, l'exécution en mode dégradé de la première instanciation de chaque instruction répliquée assure une prédiction des potentielles erreurs.

Selon un mode de mise en oeuvre du procédé de test, le taux de couverture des fautes de délai est augmenté en introduisant de manière volontaire des bulles dans un pipeline protégé avec ce procédé. Par exemple, dans le cas des pipelines dans les coeurs de processeur, cette augmentation peut être faite en insérant des opérations de type nop (terme qui vient de l'anglais "no operation") dans les programmes exécutés. Dans le cas des systèmes d'interconnections pipelinés, des bulles artificielles peuvent être introduites (a) dans les tables de gestion de la communication qui sont présentes dans certains architectures ou (b) par un arbitre central quand celui-ci est disponible, ces technologies étant connues de l'Homme du métier.

### Retour en arrière

Afin d'assurer la possibilité d'effectuer un retour en arrière propre en cas d'erreur, les résultats des opérations répliquées doivent toujours être vérifiés avant les accès non-réversibles à l'extérieur du pipeline, comme l'écriture ou la mise-à-jour des données. Afin de pouvoir faire la distinction entre les fautes transitoires et les fautes de délai, en cas d'erreur une réexécution doit commencer avec l'opération qui précède l'opération défaillante. Les résultats produits par les premières instanciations d'une opération peuvent être utilisés seulement à l'intérieur du pipeline ou pour les accès réversibles à l'extérieur du pipeline, comme la lecture des données. On peut par exemple utiliser la première instanciation d'une opération pour faire la lecture des données à l'extérieur du pipeline et les résultats de la dernière instanciation pour toute autre action.

### Différents exemples d'implémentation

L'implémentation du procédé de test selon l'invention nécessite un dispositif adapté pour exécuter les opérations décrites précédemment et indiquer la présence des opérations répliquées, notamment :
- l'identification des cycles quand les sorties du pipeline (ou de chaque étage) doivent être vérifiées,
- l'identification des cycles quand les sorties du pipeline (ou de chaque étage) peuvent être utilisées,
- l'assertion de signaux de contrôle qui permettent l'exécution de la première instanciation d'une opération répliquée en mode dégradé.

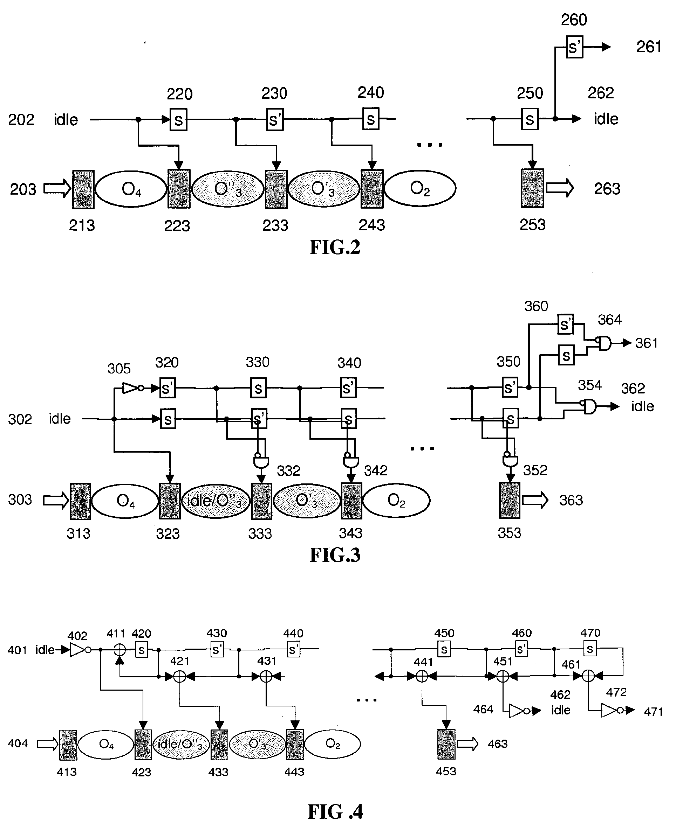

Les figures 2, 3 et 4 présentent différents modes de réalisation de dispositifs qui satisfont au moins à ces critères dans le cas où les opérations répliquées ont seulement deux instanciations.

La figure 2 présente un dispositif avec un encodage naïf des types d'opérations dans les étages d'un pipeline, qui indique les opérations qui sont des répliques des opérations précédentes. Comme un bit de statut est nécessaire pour chaque buffer (sauf le premier), le coût est d'une seule bascule (220, 230, 240 et 250) par buffer, plus les connexions qui permettent la transmission des bits de statut d'un buffer à l'autre (223, 233, 243 et 253). Les bits de statut sont transmis d'un buffer à l'autre. Seul le premier bit de statut est généré à partir du signal « idle » à l'entrée du pipeline. Le bit de statut 220 est généré par le signal 202 (idle) qui indique, par exemple, l'absence d'une opération valide à l'entrée du pipeline.

Selon cet encodage, le bit de statut stocké dans le buffer à l'entrée d'un étage exécutant une opération qui est ré-exécutée dans l'étage précédant, a une valeur s'∈{0,1}. Dans tous les autres cas, le bit de statut prend la valeur s=not(s'), avec le symbole "not" représentant l'opérateur de négation logique.

Le bit de statut associé à un buffer du pipeline peut être utilisé pour la gestion du mode dégradé dans le buffer suivant. Dans le cas du deuxième buffer 223, c'est le signal 202 (idle) à l'entrée du pipeline qui gère le mode dégradé. La valeur s' d'un bit de statut ou du signal 202 indique que le buffer concerné doit fonctionner en mode dégradé. Le premier buffer 213 du pipeline n'as pas besoin d'être mis en mode dégradé pour la protection de la logique à l'intérieur de l'étage du pipeline correspondant.

Le bit de statut dans une bascule associée à un buffer de sortie indique la validité du contenu du buffer. Dans la figure 2, c'est le cas du bit de statut 250 qui fournit le signal de validité 262 pour la sortie 263 venant du buffer 253.

La valeur s' du bit de statut associé à un buffer du pipeline indique aussi que les entrées et les sorties de ce buffer doivent être identiques. Cette indication est utile dans le cas où la comparaison des résultats produits par les différentes versions d'une opération répliquée doivent être comparées aux résultats obtenus par les versions précédentes en sortie de chaque étage du pipeline.

Dans le cas où cette comparaison est faite seulement aux sorties du pipeline, une bascule supplémentaire est nécessaire pour chaque buffer de sortie afin de stocker le bit de statut de ce buffer pendant le cycle précédent. C'est le cas de la bascule 260 produisant à sa sortie le signal 261 dont une valeur égale à s' qu'une comparaison de la sortie 263 doit être faite.

La figure 3 présente un dispositif avec le même type d'encodage que celui présenté en figure 2, exceptée la valeur s qui est remplacée par le couple (s', s) et la valeur s' par le couple (s, s'). Les deux bits de statut 320 sont obtenus à partir du signal 302 (idle) qui indique l'absence d'une opération valide à l'entrée du pipeline et à partir de l'inverse de ce signal produit par l'inverseur 305. Pour l'homme de métier, il est évident que l'inverseur 305 peut être mis à l'entrée de l'autre bascule associée au buffer 323 afin d'inverser l'encodage des bits de statut. Les portes 332, 342 et 352 permettent d'identifier l'apparition de la combinaison des bits de statut (s, s') afin de sélectionner le mode dégradé pour les buffers 333, 343 et 353. Le contrôle du mode dégradé pour le buffer 323 est fait avec le signal d'entrée 302 (idle). La porte logique 354 fournit le signal de validité 362 (idle) pour la sortie 363 venant du buffer 353. Les bits de statut 330, 340, 350 sont propagés d'un buffer à l'autre comme il a été décrit précédemment.

Comme dans la figure précédente et aussi de la figure suivante, les bits de statut sont propagés d'un buffer à l'autre.

Les deux bits de statut 350 produisent deux bits de statut 360 transmis à une porte logique 364 qui produit à sa sortie un signal 361 indiquant quand une comparaison de la sortie 363 doit être faite.

Les portes 332, 342, 352, 354 et 364 peuvent être des portes ET logique (AND) si le paramètre s est égal à 0 et des portes OU logique inversé (NOR) dans le cas contraire (s=1). La première entrée de ces portes est inversée.

La combinaison (s, s') des bits de statut associés à un buffer du pipeline indique aussi que les entrées et les sorties de ce buffer doivent être identiques. Cette indication est utile dans le cas où la comparaison des résultats produits par les différentes versions d'une opération répliquée doivent être comparées à la sortie de chaque étage du pipeline.

Cet encodage assure une protection de l'information encodée contre les fautes transitoires et les fautes de délai, mais il duplique le nombre des ressources matérielles nécessaires.

La figure 4 présente un dispositif avec un encodage des types d'opérations dans les étages d'un pipeline, qui offre la même protection des bits de statut contre les fautes transitoires et les fautes de délai que l'encodage dans la figure 3 mais avec seulement le coût de l'encodage décrit en relation avec la figure 2. Selon cet encodage, si un étage exécute une opération qui est la réplique de l'opération qui est ré-exécutée dans l'étage précédent, alors les bits de statut stockés dans les buffers à l'entrée et à la sortie de cet étage doivent avoir la même valeur. Dans tous les autres cas, les deux valeurs doivent être différentes. Le bit de statut 420 dans le deuxième buffer du pipeline est généré par le signal 401 (idle) qui indique l'absence d'une opération valide à l'entrée du pipeline. Avant d'être utilisé, le signal 401 doit passer d'abord par un inverseur logique 402.

Les combinaisons (s', s') ou (s, s) des bits de statut associés aux buffers d'entrée et de sortie d'un étage indiquent que le deuxième buffer doit capturer le résultat en mode dégradé et que les entrées et les sorties du premier buffer doivent être identiques. Dans le cas du dernier buffer, la deuxième indication est fournie par la comparaison des bits de statut dans les bascules 450 et 460. La deuxième indication est utile dans le cas où la comparaison des résultats produits par les différentes versions d'une opération répliquée doivent être comparées à la sortie de chaque étage du pipeline.

Les portes 411, 421, 431, 441, 451 et 461 implémentent l'opération OU exclusif logique (XOR). La porte 411 est utilisée pour générer le bit de statut (420) associé au deuxième buffer (423) du pipeline. Le bit 420 changera de valeur dans le cycle suivant seulement si le signal idle (401) à l'entrée du pipeline est mis à zéro logique. Les portes 421, 431 et 441 fournissent les signaux permettant la sélection du mode dégradé pour les buffers 433, 443 et 453. Le contrôle du mode dégradé pour le buffer 423 est fait avec le signal d'entrée 401 (idle). La porte logique 451 et l'inverseur 464 fournissent le signal de validité 462 (idle) pour la sortie 464 venant du buffer 453. La porte logique 461 et l'inverseur 472 produisent le signal 471 indiquant quand une comparaison de la sortie 463 doit être faite.

Pour l'homme de métier les modifications nécessaires aux dispositifs en figures 2, 3 et 4 doivent être évidentes si les signaux 'idle' aux entrées et/ou aux sorties du pipeline sont remplacés par des signaux 'valide' qui sont les inverses de signaux 'idle' (valide = not(idle)).

Dans le cas où les opérations peuvent avoir plus que deux répliques, il est nécessaire d'avoir un bit de statut supplémentaire pour chaque buffer dans le pipeline afin de distinguer entre les opérations non-répliquées et la première version, les versions suivantes et la dernière version d'une opération répliquée. Chaque bit de statut dans un buffer du pipeline peut être encodé séparément avec un des encodages présentés en figures 2 à 4. La réplication des opérations au delà de la duplication permet de limiter la puissance consommée quand les cycles non-utilisés se succèdent l'un après l'autre.

L'extension d'un des dispositifs décrits en figures 2 à 4 afin d'implémenter des pipelines avec plusieurs bits de statut par buffer doit être évidente pour l'homme de métier.

Dans le cas du pipeline d'un système d'interconnexion où le temps de propagation des bits de statut d'un buffer au suivant est comparable à la latence d'un étage du pipeline, les bits de statut doivent être décalés d'un étage en avant par rapport à l'encodage montré en figures 2, 3 ou 4.

## Revendications

1. - Procédé de test en ligne de dispositifs de type pipeline, ledit dispositif de type pipeline comportant une succession d'étages (121, 122, 123) séparés par des buffers (111, 112, 113, 114, 115), chaque buffer (111, 112, 113, 114, 115) étant en liaison avec un signal idle, ou valide = not idle, et/ou au moins un bit de statut **caractérisé en ce qu'**il comporte en combinaison au moins les étapes suivantes :
a) détecter les valeurs du signal idle et/ou des bit de statut correspondants traduisant la non utilisation d'un cycle ou l'interruption brusque du flot d'opérations dans un pipeline, et indiquant qu'une opération (O₃) exécutée par un étage du pipeline dite opération valide est suivie par un cycle non utilisé,
b) maintenir l'état du buffer (111) afin de permettre la réexécution de ladite opération valide (O₃) pendant le cycle non utilisé indiqué par ledit signal idle,
c) réexécuter pendant le cycle non utilisé l'opération valide (O₃) afin d'obtenir au moins une première version (O'₃) et une deuxième version (O"₃) de ladite opération valide (O₃),
d) mémoriser en sortie du pipeline les résultats qui correspondent à la première version (O'₃) de ladite opération (O₃) répliquée ou réexécutée afin de les comparer aux résultats de ladite deuxième version (O"₃) de la même opération (O₃) répliquée ou réexécutée,
e) comparer les résultats obtenus en sortie du pipeline qui correspondent à la première version (O'₃) et à la deuxième version (O"₃) et s'il existe une différence indiquer la présence d'une erreur.

2. - Procédé selon la revendication 1 **caractérisé en ce qu'**au niveau de l'étape b) la dernière opération valide avant un cycle non-utilisé est ré-exécutée sur plusieurs cycles successifs.

3. - Procédé selon l'une des revendications 1 à 2 **caractérisé en ce que** l'exécution de la première instanciation d'une opération répliquée est effectuée en mode dégradé.

4. - Procédé selon l'une des revendications 1 à 3 **caractérisé en ce que** l'opération de mémorisation d) des valeurs obtenues par les différentes instanciations d'une opération répliquée est exécutée en utilisant un buffer (115) dupliqué en sortie du pipeline.

5. - Procédé selon l'une des revendications 1 à 3 **caractérisé en ce que** l'opération de comparaison est exécutée à la sortie de chacun des étages constituant le pipeline.

6. - Procédé selon l'une des revendications 1 à 5 **caractérisé en ce que** l'on introduit un cycle non utilisé ou bulle à l'entrée du pipeline après chaque opération qui n'est pas naturellement suivie par un cycle non utilisé et on vérifie les résultats de chaque opération en sortie du pipeline ou au niveau de chacun des étages du pipeline.

7. - Procédé selon l'une des revendications précédentes **caractérisé en ce que** l'on utilise un encodage naïf de l'information qui décrit le type d'opération exécutée par chaque étage dans le pipeline défini de la manière suivante : on associe un bit de statut à chaque buffer, sauf le premier buffer dans le pipeline, de telle façon que le bit de statut d'un buffer à l'entrée d'un étage exécutant une opération qui correspond à une réexécution de l'opération dans l'étage précédent prend la valeur s'∈ {0, 1} et s=not(s') dans les autres cas.

8. - Procédé selon la revendication précédente **caractérisé en ce que** dans le cas où l'étape de comparaison e) est effectuée en sortie du pipeline, le procédé utilise une bascule supplémentaire associée au buffer de sortie, ladite bascule supplémentaire stockant le bit de statut de ce buffer pendant le cycle précédent.

9. - Procédé selon les revendications 7 et 8 **caractérisé en ce que** l'on utilise deux bits de statut dans le cas où les opérations ont plus que deux répliques afin de distinguer entre les opérations non-répliquées et la première version, les versions suivantes et la dernière version d'une opération répliquée, chacun des bits de statut pouvant être encodé séparément.

10. - Utilisation du procédé selon l'une des revendications précédentes pour des pipelines dans les coeurs des processeurs où des cycles temporairement non utilisés sont obtenus en insérant des opérations de type « no opération ».

11. - Utilisation du procédé selon l'une des revendications 1 à 9 pour des pipelines dans les systèmes d'interconnections où les bits de statut sont décalées d'un étage de pipeline en avant.

12. - Utilisation du procédé selon l'une des revendications 1 à 6 pour des pipelines dans les systèmes d'interconnections où des cycles temporairement non utilisés sont inclus dans les tables de gestion ou sont générés par un arbitre central.

13. - Dispositif de test en ligne pour des dispositifs de type pipeline composés d'une succession d'étages séparés par des buffers (223, 233, 243, 253), ledit dispositif de test en ligne étant adapté à l'implémentation du procédé selon les revendications 1 à 9 **caractérisé en ce qu'**il comporte au moins les éléments suivants : un moyen d'encodage naïf des types d'opération existantes dans les étages dudit pipeline, indiquant les opérations dupliquées et leurs versions, constitué d'un bit de statut associé à chaque buffer à la fin d'un étage de pipeline de telle façon que le bit de statut d'un buffer à l'entrée d'un étage exécutant une opération qui correspond à une réexécution dans l'étage précédente prend la valeur s'∈{0, 1} et s=not(s') dans les autres cas afin de sélectionner le mode dégradé pour les buffers à la fin de chaque étage de pipeline qui exécute la première version d'une opération dupliquée, de comparer les résultats et de choisir entre les résultats produits par les deux versions d'une opération dupliquée.

14. - Dispositif selon la revendication 13 **caractérisé en ce qu'**il comporte une bascule pour stocker chaque bit de statut.

15. - Dispositif selon les revendications 13 et 14 **caractérisé en ce que** le bit de statut s' prend la valeur {s, s'}, le bit de statut s=not(s') prend la valeur {s', s}, chaque paire de bits de statut (320) étant obtenus à partir d'un signal (302) indiquant l'absence d'une opération valide à l'entrée du pipeline et à partir de ce même signal inversé par un inverseur (305), et **en ce qu'**il comporte des moyens (332, 342, 352) permettant d'identifier l'apparition de la combinaison (s, s') afin de sélectionner le mode dégradé pour les buffers à la fin de chaque étage de pipeline qui exécute la première version d'une opération dupliquée, de comparer les résultats et de choisir entre les résultats produits par les deux versions d'une opération dupliquée.

16. - Dispositif selon la revendication 15 **caractérisé en ce que** les moyens d'identification de l'apparition de la combinaison (s, s') sont choisis parmi la liste des moyens suivants : les portes ET logique si le paramètre s est égal à 0, des portes OU logique inversé lorsque s=1.

17. - Dispositif selon les revendications 13 et 14 **caractérisé en ce que** l'information transportée par le bit de statut associé à un buffer est donnée par la comparaison avec le bit du statut du buffer suivant, la valeur du premier bit de statut dans le pipeline pendant un cycle d'horloge étant obtenu à partir de sa valeur pendant le cycle d'horloge précédant comparée avec le signal d'entrée (401) indiquant l'absence d'une opération valide à l'entrée du pipeline, et **en ce qu'**il comporte des portes OU exclusif logique XOR (421, 431, 441, 451, 461) et des inverseurs logiques (464, 472) permettant d'identifier les opérations dupliquées et leurs versions afin de sélectionner le mode dégradé pour les buffers à la fin de chaque étage de pipeline qui exécute la première version d'une opération dupliquée, de comparer les résultats et de choisir entre les résultats produits par les deux versions d'une opération dupliquée.

18. - Dispositif selon les revendications 13 à 17 **caractérisé en ce qu'**un buffer comporte un nombre double de bits de statut dans le cas où les opérations ont plus que deux répliques afin de distinguer entre les opérations non-répliquées et la première version, les versions suivantes et la dernière version d'une opération répliquée, chacun des bits de statut pouvant être encodé séparément.

## Patentansprüche

1. Verfahren zum Online-Testen von Vorrichtungen des Pipeline-Typs, wobei die Vorrichtung des Pipeline-Typs eine Folge von durch Puffer (111, 112, 113, 114, 115) getrennten Stufen (121, 122, 123) umfasst, wobei jeder Puffer (111, 112, 113, 114, 115) mit einem Idle-Signal, wobei gültig = nicht idle ist, und/oder wenigstens einem Statusbit in Verbindung ist, **dadurch gekennzeichnet, dass** es in Kombination wenigstens die folgenden Schritte beinhaltet:
a) Erkennen der Werte des Idle-Signals und/oder der entsprechenden Statusbits, die eine Nichtnutzung eines Zyklus oder eine abrupte Unterbrechung des Operationsflusses in einer Pipeline wiedergeben und anzeigen, dass auf eine durch eine Stufe der Pipeline ausgeführte Operation (O₃), gültige Operation genannt, ein unbenutzter Zyklus folgt,
b) Halten des Zustands des Puffers (111), um die erneute Ausführung der gültigen Operation (O₃) während des durch das Idle-Signal angezeigten unbenutzten Zyklus zuzulassen,
c) erneutes Ausführen der gültigen Operation (O₃) während des unbenutzten Zyklus, um wenigstens eine erste Version (O'₃) und eine zweite Version (O"₃) der gültigen Operation (O₃) zu erhalten,
d) Speichern, am Ausgang der Pipeline, der Ergebnisse, die der ersten Version (O'₃) der replizierten oder erneut ausgeführten Operation (O₃) entsprechen, um sie mit den Ergebnissen der zweiten Version (O"₃) derselben replizierten oder erneut ausgeführten Operation (O₃) zu vergleichen,
e) Vergleichen der am Ausgang der Pipeline erhaltenen Ergebnisse, die der ersten Version (O'₃) und der zweiten Version (O"₃) entsprechen, und Anzeigen, wenn eine Differenz vorliegt, der Anwesenheit eines Fehlers.

2. Verfahren nach Anspruch 1, **dadurch gekennzeichnet, dass** in Stufe b) die letzte gültige Operation vor einem unbenutzten Zyklus bei mehreren aufeinander folgenden Zyklen erneut ausgeführt wird.

3. Verfahren nach einem der Ansprüche 1 bis 2, **dadurch gekennzeichnet, dass** die Ausführung der ersten Instanziierung einer replizierten Operation im herabgesetzten Modus erfolgt.

4. Verfahren nach einem der Ansprüche 1 bis 3, **dadurch gekennzeichnet, dass** die Speicheroperation d) der durch die verschiedenen Instanziierungen einer replizierten Operation erhaltenen Werte unter Verwendung eines am Ausgang der Pipeline duplizierten Puffers (115) erfolgt.

5. Verfahren nach einem der Ansprüche 1 bis 3, **dadurch gekennzeichnet, dass** die Vergleichsoperation am Ausgang jeder die Pipeline bildenden Stufe ausgeführt wird.

6. Verfahren nach einem der Ansprüche 1 bis 5, **dadurch gekennzeichnet, dass** ein unbenutzter Zyklus oder eine Blase am Eingang der Pipeline nach jeder Operation eingeführt wird, auf die nicht natürlich ein unbenutzter Zyklus folgt, und Überprüfen der Ergebnisse jeder Operation am Ausgang der Pipeline oder auf jeder der Stufen der Pipeline.

7. Verfahren nach einem der vorherigen Ansprüche, **dadurch gekennzeichnet, dass** eine naive Codierung der Informationen benutzt wird, die den von jeder Stufe in der Pipeline ausgeführten Operationstyp beschreibt, der wie folgt definiert wird: Assoziieren eines Statusbits mit jedem Puffer, mit Ausnahme des ersten Puffers in der Pipeline, so dass das Statusbit eines Puffers am Eingang einer eine Operation ausführenden Stufe, die einer erneuten Ausführung der Operation in der vorherigen Stufe entspricht, den Wert s'∈{0,1} und in den anderen Fällen s=not(s') annimmt.

8. Verfahren nach dem vorherigen Anspruch, **dadurch gekennzeichnet, dass** das Verfahren, falls die Vergleichsstufe e) am Ausgang der Pipeline erfolgt, einen mit dem Ausgangspuffer assoziierten zusätzlichen Flipflop benutzt, wobei der zusätzliche Flipflop das Statusbit dieses Puffers während des vorherigen Zyklus speichert.

9. Verfahren nach den Ansprüchen 7 und 8, **dadurch gekennzeichnet, dass** zwei Statusbits benutzt werden, falls die Operationen mehr als zwei Replikate haben, um zwischen den nicht replizierten Operationen und der ersten Version, den folgenden Versionen und der letzten Version einer replizierten Operation zu unterscheiden, wobei jedes der Statusbits separat codiert werden kann.

10. Anwendung des Verfahrens nach einem der vorherigen Ansprüche auf Pipelines in den Kernen der Prozessoren, wo die vorübergehend unbenutzten Zyklen unter Einfügung von Operationen des Typs "no operation" erhalten werden.

11. Anwendung des Verfahrens nach einem der Ansprüche 1 bis 9 auf Pipelines in den Verbindungssystemen, wo die Statusbits um eine Pipeline-Stufe nach vorne versetzt sind.

12. Anwendung des Verfahrens nach einem der Ansprüche 1 bis 6 auf Pipelines in den Verbindungssystemen, wo vorübergehend unbenutzte Zyklen in den Managementtabellen enthalten sind oder von einem zentralen Arbiter erzeugt werden.

13. Vorrichtung zum Online-Prüfen für Vorrichtungen des Pipeline-Typs, die sich aus einer Folge von durch Puffer (223, 233, 243, 253) getrennten Stufen zusammensetzen, wobei die Vorrichtung zum Online-Prüfen zur Implementation des Verfahrens nach den Ansprüchen 1 bis 9 angepasst ist, **dadurch gekennzeichnet, dass** sie wenigstens die folgenden Elemente beinhaltet: Mittel zum naiven Codieren von Operationstypen, die in den Stufen der Pipeline existieren, die die duplizierten Operationen und deren Versionen anzeigen, gebildet von einem mit jedem Puffer am Ende einer Pipeline-Stufe assoziierten Statusbit, so dass das Statusbit eines Puffers am Eingang einer Stufe, die eine Operation ausführt, die einer Neuausführung in der vorherigen Stufe entspricht, den Wert s'∈ {0,1} und in den anderen Fällen s=not(s') annimmt, um den herabgesetzten Modus für die Puffer am Ende jeder Pipeline-Stufe auszuwählen, die die erste Version einer duplizierten Operation ausführt, Vergleichen der Ergebnisse und Auswählen zwischen den von den beiden Versionen einer duplizierten Operation erzeugten Ergebnisse.

14. Vorrichtung nach Anspruch 13, **dadurch gekennzeichnet, dass** sie einen Flipflop zum Speichern von jedem Statusbit umfasst.

15. Vorrichtung nach den Ansprüchen 13 und 14, **dadurch gekennzeichnet, dass** das Statusbit s' den Wert {s, s'} annimmt, das Statusbit s=not(s') den Wert {s', s} annimmt, wobei jedes Paar Statusbits (320) von einem Signal (302) erhalten wird, das die Abwesenheit einer gültigen Operation am Eingang der Pipeline anzeigt, und von demselben Signal, das durch einen Inverter (305) invertiert wird, und dadurch, dass sie Mittel (332, 342, 352) umfasst, um das Erscheinen der Kombination (s, s') identifizieren zu können, um den herabgesetzten Modus für die Puffer am Ende jeder Pipeline-Stufe auszuwählen, die die erste Version einer duplizierten Operation ausführt, Vergleichen der Ergebnisse und Auswählen zwischen den durch die beiden Versionen einer duplizierten Operation erzeugten Resultaten.

16. Vorrichtung nach Anspruch 15, **dadurch gekennzeichnet, dass** die Mittel zum Identifizieren der Erscheinung der Kombination (s, s') aus der Liste der folgenden Mittel ausgewählt sind: logische UND-Ports, wenn der Parameter s gleich 0 ist, umgekehrte logische ODER-Ports, wenn s=1.

17. Vorrichtung nach den Ansprüchen 13 oder 14, **dadurch gekennzeichnet, dass** die Information, die von dem mit einem Puffer assoziierten Statusbit transportiert wird, durch den Vergleich mit dem Statusbit des folgenden Puffers angegeben wird, wobei der Wert des ersten Statusbits in der Pipeline während eines Taktzyklus von seinem Wert während des vorhergehenden Taktzyklus erhalten wird, verglichen mit dem Eingangssignal (401), das die Abwesenheit einer gültigen Operation am Eingang der Pipeline anzeigt, und dadurch, dass sie logische Exklusiv-ODER-Ports (XOR) (421, 431, 441, 451, 461) und logische Umkehr-Ports (464, 472) umfasst, so dass die duplizierten Operationen und deren Versionen identifiziert werden können, um den herabgesetzten Modus für die Puffer am Ende jeder Pipeline-Stufe auszuwählen, die die erste Version einer duplizierten Operation ausführt, Vergleichen der Ergebnisse und Auswählen zwischen den durch die beiden Versionen einer duplizierten Operation erzeugten Ergebnisse.

18. Vorrichtung nach den Ansprüchen 13 bis 17, **dadurch gekennzeichnet, dass** ein Puffer eine doppelte Anzahl von Statusbits in dem Fall umfasst, in dem die Operationen mehr als zwei Replikate haben, um zwischen den nicht replizierten Operationen und der ersten Version, den folgenden Versionen und der letzten Version einer replizierten Operation zu unterscheiden, wobei jedes der Statusbits separat codiert werden kann.

## Claims

1. - A method for online testing pipeline systems, said pipeline system comprising a succession of stages (121, 122, 123) separated by buffers (111, 112, 113, 114, 115), each buffer (111, 112, 113, 114, 115) being associated with an idle signal, or valid = not idle signal, and/or at least one status bit, **characterized in that** it comprises, in combination, at least the following steps:
a) detecting values of the idle signal and/or the corresponding status bits indicating the availability of a cycle or the abrupt interruption of the flow of operations in a pipeline, and indicating that an operation (O₃), called a valid operation, executed by a stage in the pipeline, is followed by an unused cycle;
b) maintaining the state of the buffer (111) in order to allow said valid operation (O₃) to be re-executed during the unused cycle indicated by said idle signal;
c) re-executing, during the unused cycle, the valid operation (O₃), in order to obtain at least a first version (O'₃) and a second version (O"₃) of said valid operation (O₃);
d) memorizing, at the output of the pipeline, the results that correspond to the first version (O'₃) of said repeated or re-executed operation (O₃), in order to compare them with the results of said second version (O"₃) of the same repeated or re-executed operation (O₃); and
e) comparing the results obtained at the output of the pipeline, which results correspond to the first version (O'₃) and the second version (O"₃), and, if there is a difference, indicating the presence of an error.

2. - The method as claimed in claim 1, **characterized in that**, in step b), the last valid operation before an unused cycle is re-executed in a plurality of successive cycles.

3. - The method as claimed in either of claims 1 and 2, **characterized in that** the first instance of a repeated operation is executed in degraded mode.

4. - The method as claimed in one of claims 1 to 3, **characterized in that** the operation d) of memorizing the values obtained by the various instances of a repeated operation is executed using a duplicated buffer (115), at the output of the pipeline.

5. - The method as claimed in one of claims 1 to 3, **characterized in that** the comparison operation is executed at the output of each of the stages forming the pipeline.

6. - The method as claimed in one of claims 1 to 5, **characterized in that** an unused cycle or bubble is inserted at the input of the pipeline after each operation that is not naturally followed by an unused cycle and the results of each operation are checked at the output of the pipeline or at each of the stages in the pipeline.

7. - The method as claimed in one of the preceding claims, **characterized in that** naive coding is used to encode the information that describes the type of operation executed by each stage in the pipeline, defined as follows: a status bit is associated with each buffer, except the first buffer in the pipeline, such that the status bit of a buffer at the input of a stage executing an operation that corresponds to a re-execution of the operation in the preceding stage takes the value s'∈ {0,1}, and s=not(s') in any other case.

8. - The method as claimed in the preceding claim, **characterized in that**, in the case where comparison step e) is carried out at the output of the pipeline, the method uses an additional flip-flop associated with the output buffer, said additional flip-flop storing the status bit of this buffer during the preceding cycle.

9. - The method as claimed in claims 7 and 8, **characterized in that** two status bits are used in the case where operations are repeated more than twice, in order to distinguish between unrepeated operations and the first version, the following versions and the last version of a repeated operation, each of the status bits possibly being separately coded.

10. - The use of the method as claimed in one of the preceding claims for pipelines in the cores of processors where temporarily unused cycles are obtained by inserting operations of the "no operation" type.

11. - The use of the method as claimed in one of claims 1 to 9 for pipelines in interconnect systems where the status bits are shifted forward by one pipeline stage.

12. - The use of the method as claimed in one of claims 1 to 6 for pipelines in interconnect systems where temporarily unused cycles are included in management tables or are generated by a central arbiter.

13. - An online testing device for pipeline systems composed of a succession of stages separated by buffers (223, 233, 243, 353), said online testing device being capable of implementing the method as claimed in claims 1 to 9, **characterized in that** it comprises at least the following elements: a means for naive coding the types of operation carried out in the stages in said pipeline, indicating the duplicated operations and their versions, consisting of a status bit associated with each buffer at the end of a pipeline stage such that the status bit of a buffer at the input of a stage executing an operation that corresponds to a re-execution in the preceding stage takes the value s'∈ {0,1}, and s=not(s') in any other case, in order to select the degraded mode for the buffers at the end of each pipeline stage that executes the first version of a duplicated operation; means for comparing the results; and means for choosing between the results produced by two versions of a duplicated operation.

14. - The device as claimed in claim 13, **characterized in that** it comprises a flip-flop for storing each status bit.

15. - The device as claimed in claims 13 and 14, **characterized in that** the status bit s' takes the value {s, s'}, the status bit s=not(s') takes the value {s', s}, each pair of status bits (320) being obtained from a signal (302) indicating the absence of a valid operation at the input of the pipeline and from this same signal inverted by an inverter (305), and **in that** it comprises means (332, 342, 352) allowing the appearance of the combination (s, s') to be identified in order to select the degraded mode for the buffers at the end of each pipeline stage that executes the first version of a duplicated operation, means for comparing the results, and means for choosing between the results produced by two versions of a duplicated operation.

16. - The device as claimed in claim 15, **characterized in that** the means for identifying the appearance of the combination (s, s') are chosen from the list of following means: AND logic gates if the parameter s is equal to 0, or OR logic gates when s=1.

17. - The device as claimed in claims 13 and 14, **characterized in that** the information conveyed by the status bit associated with a buffer is read by comparing it with the status bit of the following buffer, the value of the first status bit in the pipeline during a clock cycle being obtained by comparing its value during the preceding clock cycle with the input signal (401) indicating the absence of a valid operation at the input of the pipeline, and **in that** it comprises XOR logic gates (421, 431, 441, 451, 461) and logic inverters (464, 472) allowing duplicated operations and their versions to be identified in order to select the degraded mode for buffers at the end of each pipeline stage that executes the first version of a duplicated operation, the results to be compared, and the results produced by the two versions of a duplicated operation to be chosen between.

18. - The device as claimed in claims 13 to 17, **characterized in that** a buffer comprises double the number of status bits in the case where the operations are repeated more than twice, in order to distinguish between unrepeated operations and the first version, the following versions and the last version of a repeated operation, each of the status bits possibly being separately coded
